# FASCICULE DE BREVET EUROPEEN

(11) **EP 2 735 036 B1**
(45) Date de publication et mention de la délivrance du brevet: **17.06.2020**
(21) Numéro de dépôt: 12758623.8
(22) Date de dépôt: 20.07.2012
(51) Int. Cl.: H01L 51/10

(54) **UTILISATION DE COUCHES AUTO-ASSEMBLÉES POUR LE CONTRÔLE DE LA TENSION DE SEUIL DE TRANSISTORS ORGANIQUES**
VERWENDUNG SELBSTASSEMBLIERTER SCHICHTEN ZUR ANPASSUNG DER SCHWELLENSPANNUNG VON ORGANISCHEN TRANSISTOREN
USE OF SELF-ASSEMBLED LAYERS FOR ADJUSTING THE THRESHOLD VOLTAGE OF ORGANIC TRANSISTORS

(30) Priorité: 22.07.2011 FR 1156684
(43) Date de publication de la demande: 28.05.2014
(73) Titulaire: Commissariat à l'Énergie Atomique et aux Énergies Alternatives, 75015 Paris (FR)
(72) Inventeur: SIMONATO, Jean-Pierre, 38360 Sassenage (FR); CELLE, Caroline, 42700 Firminy (FR)
(74) Mandataire: Gevers & Orès
(86) Numéro de dépôt international: PCT/IB2012/053720
(87) Numéro de publication internationale: WO 2013/014592

(56) Documents cités:
- EP-A2- 1 496 554
- US-A1- 2008 290 337
- CHENG HUANG ET AL: "Solution-Processed Organic Field-Effect Transistors and Unipolar Inverters Using Self-Assembled Interface Dipoles on Gate Dielectrics", LANGMUIR, vol. 23, no. 26, 1 décembre 2007 (2007-12-01), pages 13223-13231, XP055014836, ISSN: 0743-7463, DOI: 10.1021/la702409m
- PERNSTICH K ET AL: "Threshold voltage shift in organic field effect transistors by dipole monolayers on the gate insulator", JOURNAL OF APPLIED PHYSICS, AMERICAN INSTITUTE OF PHYSICS. NEW YORK, US, vol. 96, no. 11, 1 janvier 2004 (2004-01-01), pages 6431-6438, XP012068321, ISSN: 0021-8979, DOI: 10.1063/1.1810205
- Anonymous: "Product sheet Phenyltrimethoxysilane", , 14 August 2017 (2017-08-14), XP055398454, Retrieved from the Internet: URL:https://www.gelest.com/product/phenylt rimethoxysilane/ [retrieved on 2017-08-14]

## Description

L'invention concerne un dispositif électronique comprenant au moins deux transistors organiques ayant des tensions de seuil différentes ainsi qu'un procédé de fabrication de circuits électroniques comprenant au moins deux transistors organiques ayant des tensions de seuil différentes.

Par transistor organique on entend, dans l'invention, tout dispositif comprenant trois électrodes (source, drain, grille), et une couche en un composé diélectrique séparant l'électrode de grille d'une couche en un matériau semiconducteur organique. Par semiconducteur organique, on entend, dans l'invention, un composé dont la masse est au moins à 50% à base de composés organiques.

Un point crucial pour la réalisation de circuits électroniques à base de transistors organiques est le contrôle de la tension de seuil des transistors, c'est-à-dire la tension de grille à appliquer pour générer la transition entre le comportement bloqué du transistor et son comportement conducteur.

En effet, la tension de seuil du transistor organique est un élément capital pour la réalisation de circuits à l'échelle industrielle.

Les dépôts de couches de semiconducteurs organiques sur des surfaces présentant des énergies de surface différentes est, en soi, un problème significatif. Ceci est d'autant plus vrai pour les matériaux semiconducteurs organiques cristallins ou semi-cristallins pour lesquels la cristallisation est un facteur essentiel pour l'obtention de bonnes performances. Kobayashi et al. dans Nature Materials, Vol 3, Mai 2004 p317-322 et Wu et al. dans APPLIED PHYSICS LETTERS, 86, 142102 (2005) ont démontré que l'utilisation de couches moléculaires peut permettre de modifier la tension de seuil de transistors organiques à base de semiconducteurs amorphes, cristallins ou semi-cristallins. Cette variation de tension de seuil est attribuée principalement à l'existence de charges de surface à l'interface du matériau diélectrique/matériau semiconducteur organique.

Néanmoins, pour les matériaux cristallins ou semi-cristallins, une modification sensible des performances des transistors est observée, en plus de la variation de la tension de seuil. Par exemple, la mobilité des porteurs de charge varie très significativement. Cela est attribué au fait que la cristallisation se produit différemment suivant les énergies de surface qui varient en fonction des couches monomoléculaires utilisées. En effet les molécules qui composent les couches moléculaires comportent des motifs terminaux qui diffèrent, et qui donc induisent une amorce de cristallisation différente.

C. Huang et al., LANGMUIR, 23, 13223 (2007) divulgue l'utilisation de couches moléculaires dans un inverseur comprenant deux transistors organiques de type p.

Au regard des technologies existantes et de la nécessité de trouver une solution permettant d'obtenir un ensemble de transistors ayant les mêmes propriétés physiques, à l'exception de la tension de seuil qui peut être modulée à façon, la présente invention a pour but de s'affranchir des problèmes qui existent dans l'état de l'art.

A cet effet, l'invention propose un dispositif électronique comprenant un premier transistor organique ayant une tension de seuil V₁ et au moins un second transistor organique ayant une tension de seuil V₂, V₁ et V₂ différant de l'un de l'autre d'une valeur d'au moins 0,2 V, chacun des premier et au moins un second transistors comprenant une couche en un matériau semiconducteur au dessus d'une couche en un matériau diélectrique, caractérisé en ce qu'il comprend de plus :
- une première couche auto-assemblée de molécules ayant un premier moment dipolaire M₁, entre la couche en matériau diélectrique et la couche en un matériau semiconducteur du premier transistor organique, et
- une seconde couche auto-assemblée de molécules ayant un second moment dipolaire M₂ entre la couche en un matériau diélectrique et la couche en un matériau semiconducteur du second transistor organique,
la valeur absolue de la différence entre le moment dipolaire M₁ et le moment dipolaire M₂, |M₁-M₂|, est comprise entre 0,2 et 10 Debye.

L'invention propose aussi un procédé de fabrication de circuits électroniques comprenant un premier transistor organique et au moins un second transistor organique, chacun des premier et au moins un second transistors organiques comprenant une couche en un matériau semiconducteur au dessus d'une couche en un matériau diélectrique caractérisé en ce qu'il comprend les étapes suivantes :
a) formation sur la couche en un matériau diélectrique du premier transistor, d'une couche auto-assemblée à partir de molécules ayant un moment dipolaire M₁, et
b) formation, sur la couche en un matériau diélectrique du au moins un second transistor organique, d'une couche auto-assemblée, à partir de molécules ayant un moment dipolaire M₂ tel que la valeur absolue |M₁-M₂| est comprise entre 0,2 et 10 Debye.

Les molécules à partir desquelles les couches auto-assemblées du premier et du au moins un second transistors organiques ont la formule I suivante :

A-D-Z Formule I

dans laquelle :
- A est un groupement de greffage de la molécule de formule I sur le matériau diélectrique, de préférence un groupement trihalogénosilane, trialcoxysilane, acide carboxylique, acide phosphorique, un composé insaturé, de préférence comprenant un groupement vinylique ou acétylènique, un sel de diazonium, un azoture, un composés initiateur de radicaux, un isocyanate, un groupement de type organolithien, organomagnésien, ou organozincique, ou un acide sulfonique,
- Z est un groupement terminal comprenant de 3 à 8 atomes de carbone, linéaire ou ramifié ou aromatique, comprenant optionnellement au moins un atome de fluor,
- D est une chaine carbonée linéaire ou ramifiée, saturée ou insaturée, comprenant éventuellement un groupe cyclique, éventuellement aromatique, et/ou plusieurs hétéroatomes,
la différence entre la valeur de l'angle de goutte à l'eau de la couche auto-assemblée du premier transistor organique et la valeur de l'angle de goutte à l'eau de la couche auto-assemblée du au moins un second transistor organique, est inférieure à 5%, de préférence inférieure à 3%.

Dans un premier mode de mise en œuvre préféré du procédé de l'invention, le matériau diélectrique des premier et au moins un second transistor est à base de silicium, d'alumine ou de polymère oxydé en surface, et le groupement de greffage A des molécules de formule I est un groupement trihalogénosilane ou trialcoxy (en C₁ à C₄) silane, de préférence un groupement triméthoxysilane, trichlorosilane ou triéthoxysilane.

De préférence, dans la formule I le groupement D comprend un noyau aromatique, éventuellement substitué.

Toujours de préférence, le groupement terminal Z dans les composés de formule I est choisi parmi un groupe alkyle en C₃ à C₈, linéaire ou ramifié, saturé ou insaturé, comprenant optionnellement un atome de fluor et/ou un groupe aromatique. De préférence Z est choisi parmi un groupe terbutyle, isopropyle, adamantyle, perfluoroéthyle ou benzyle ou butyle.

Plus préférablement, les molécules de formule I à partir desquelles les couches auto-assemblées des transistors sont formées ont la formule I' suivante : 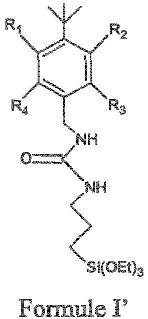 dans laquelle R₁, R₂, R₃ et R₄ représentent, indépendamment les uns des autres des groupements électroatracteurs ou électrodonneurs.

De préférence, les groupes R₁, R₂, R₃ et R₄ dans la formule I' sont choisis, indépendamment les uns des autres, parmi un atome d'hydrogène, un groupe alkyle en C₁-C₁₀, substitué ou non substitué, un atome d'halogène, un groupe nitro (-NO₂), ester, amide, trifluométhyle, dialkylamide, alcoxy, cyano, aldhéhyde, cétone, acide carboxylique (-COOH) ou amine (-NH₂).

Le plus préférablement, les molécules de formule I à partir desquelles sont formée les couches auto-assemblées des transistors sont choisies parmi les molécules de formules L, M et N suivantes :

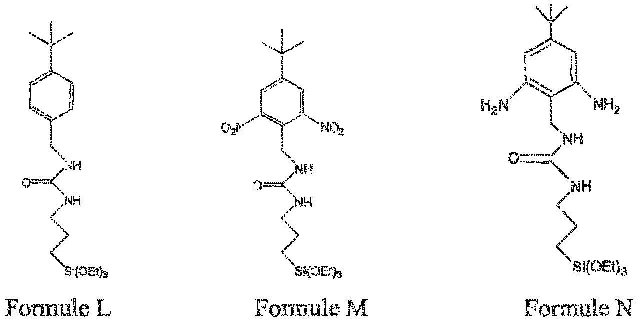

Ces molécules ont la formule I' dans laquelle, pour la formule L, R₁, R₂, R₃ et R₄ sont H, pour la formule M, R₁ et R₂ sont H et R₃ et R₄ sont -NO₂, et pour la formule N, R₁ et R₂ sont H et R₃ et R₄ sont -NH₂.

L'invention sera mieux comprise et d'autres caractéristiques et avantages de celle-ci apparaîtront plus clairement à la lecture de la description explicative qui suit.

L'invention propose un procédé de fabrication de circuits électroniques comprenant au moins deux transistors organiques, chacun de ces transistors organiques comprenant une couche en un même matériau semiconducteur ou en des matériaux semiconducteurs différents mais déposés sur un matériau diélectrique qui, lui, est modifié, à différents endroits par des couches moléculaires auto-assemblées différentes dans le premier et le au moins un second transistor organique.

Par matériau semiconducteur organique on entend, dans l'invention, un composé dont la masse est au moins à 50 % à base de composés organiques. Parmi ceux-ci sont compris les semiconducteurs amorphes, semicristallins ou cristallins, de type p ou n. Des exemples de composés semiconducteurs organiques sont le pentacène, les dérivés du pentacène tels que l'anthratiophène, l'anthradithiophène ou le triéthylsilyléthynyl-anthradithiophène, les polyalkylthiophènes et leurs dérivés connus sous les noms P3HT, PQT12, F8T2, P3OT, les diimides de naphtalènes et pérylènes (les structures de base naphtalènes et pérylènes pouvant être éventuellement modifiées et/ou substituées), les polytriarylamines et leurs dérivés, les phtalocyanines de cuivre, etc.

Les molécules à partir desquelles les couches moléculaires auto-assemblées différentes sont formées sur la couche en un matériau diélectrique de chacun des transistors appartiennent à la même famille de molécules. Elles présentent toutes une fonction d'accroche covalente pour greffer la molécule sur le matériau diélectrique (groupe A dans la formule I) ou constituant la grille des transistors et ont un moment dipolaire différent inhérent à la structure chimique de chaque molécule (plus précisément groupe D+Z dans la formule I) mais une même énergie de surface lorsqu'elles sont assemblées en couche moléculaire. Cette même énergie de surface est obtenue par le fait que toutes les molécules de cette famille possèdent des fonctions terminales (groupe Z dans la formule I) identiques ou similaires. Les couches auto-assemblées obtenues à partir de ces molécules présentent entre elles une différence de valeurs d'angle de goutte à l'eau inférieure à 5%, de préférence inférieure à 3%.

Les molécules utilisées pour former chaque couche moléculaire à l'interface entre la couche en matériau semiconducteur et la couche en matériau diélectrique sont des familles de molécules de formule I suivante :

A-D-Z formule I

Dans ces molécules, le groupement A est un groupement réactif qui permet le greffage par une ou des liaisons covalentes sur la couche en matériau diélectrique. Ce groupement peut être un groupe trihalogénosilane, trialcoxysilane, acide carboxylique, acide phosphorique ou acide sulfonique, un groupe insaturé, par exemple de type vinylique ou acétylènique, un sel de diazonium ou un dérivé de sel de diazonium, un groupement azoture, un groupement initiateur de radicaux, un groupement isocyanate ou un dérivé d'isocyanate, ou encore de type organolithien, organomagnésien, ou organozincique.

Dans les molécules de formule I, D est la partie centrale de la molécule. La structure de cette partie centrale D est modifiée de façon à ce que les couches moléculaires obtenues à partir de ces molécules sur les différentes couches en matériau diélectriques, possèdent un moment dipolaire spécifique.

De préférence, les parties centrales D des molécules de formule I seront composées d'un noyau aromatique substitué, dont les substituants induisent des moments dipolaires variés.

Ainsi, on utilisera, pour fabriquer des circuits électroniques comprenant un premier transistor organique et un second transistor organique, un premier type de molécules de formule I ayant un moment dipolaire M₁ et un second type de molécules de formule I ayant un moment dipolaire M₂ tel que la valeur absolue de la différence entre ces moments dipolaire M₁ et M₂ est comprise entre 0,2 et 10 Debye.

Lorsque le circuit électronique comprend trois transistors organiques, trois types de molécules de formule I serviront à former trois couches auto-assemblées sur chacune des couches respectives en un matériau diélectrique de chacun des transistor. Dans ce cas, la différence entre les moments dipolaires des trois ensembles (D+Z) de chaque molécule de formule I sera d'au moins 0,2 Debye.

Le groupement Z dans les molécules de formule I est le groupement terminal de la molécule de formule I. Une famille de molécules de formule I possédera la même fonction terminale ou une fonction terminale telle que l'énergie de surface mesurée sur une couche auto-assemblée réalisée à partir de cette famille de molécules soit similaire (c'est-à-dire présentant un angle de goutte de valeurs dispersées de moins de 5%). De préférence le groupement terminal est un groupement alkyle, éventuellement fluoré, ou un groupement aromatique, générant une énergie de surface quasi-identique.

Par exemple un groupement alkyle, un groupe fluoré et, un groupement aromatique sont de natures différentes mais génèrent une énergie de surface quasi-identique. Ce groupe est composé d'au moins 3 atomes de carbone et comprend au maximum 8 atomes de carbone.

Dans un mode de réalisation préféré, ce groupe terminal Z est choisi parmi un groupement terbutyle, isopropyle, adamantyle, perfluoroéthyle, benzyle ou butyle.

Les molécules qui seront utilisées pour former les différentes couches auto-assemblées doivent former des couches auto-assemblées ayant entre elles, une différence de valeur d'angle de goutte à l'eau inférieure à 5%, de préférence inférieur à 3%. Ainsi, lorsque deux molécules de formule I différentes sont utilisées, la différence de la mesure de leur angle de goutte à l'eau des couches auto-assemblées formées doit être inférieure à 5%, de préférence inférieure à 3%. Il en est de même, lorsque trois molécules sont utilisées, si la première molécule mène à une couche auto-assemblée ayant une valeur d'angle de goutte à l'eau x₁, les deux autres molécules doivent mener à des couches auto-assemblées ayant une différence de valeur d'angle de goutte à l'eau, part rapport à cette valeur x₁, inférieure à 5%, de préférence inférieure à 3% et avoir également entre elles une différence de valeur d'angle de goutte à l'eau inférieure à 5%, de préférence à 3%.

Ainsi, le moment dipolaire de la première molécule, noté M₁, et le moment dipolaire de la seconde molécule, noté M₂, ainsi que le moment dipolaire de la troisième molécule, noté M₃, doivent être tels que les valeurs absolues |M₁-M₂| et |M₁-M₃| et |M₂-M₃| soient supérieures ou égales à 0,2 Debye.

La mesure des moments dipolaires des parties (D+Z) des molécules de formule I sont effectuées par la méthode semi-empirique PM3 avec le logiciel MOPAC® version 2009.

Les mesures d'angle de goutte à l'eau sont effectuées selon la méthode classique en utilisant une caméra et un goniomètre.

Dans un mode de réalisation préféré, les molécules sont de la même famille avec une fonction terminale Z qui est un groupe tertbutyle mais diffèrent par leurs parties centrales D qui possèdent des moments dipolaires différents en raison des groupements présents sur la chaîne constituant les parties centrales D.

Une famille préférée de telles molécules sont les molécules de formule I' suivante : 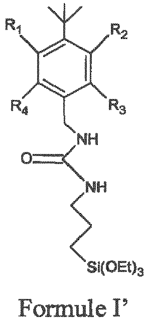 dans laquelle R₁, R₂, R₃ et R₄ sont choisis indépendamment les uns des autres, parmi des groupements électro-attracteurs ou électro-donneurs.

De préférence, les groupements R₁, R₂, R₃ et R₄ de la formule I' sont choisis parmi un atome d'hydrogène, un groupe alkyle en C₁-C₁₀ substitué ou non substitué, un atome d'halogène, un groupe nitro (-NO₂), ester, amide, trichlorométhyle, dialkylamine, alcoxy, cyano, aldhéyde, cétone, acide carboxylique (-COOH), ou amine (-NH₂).

Dans la formule I', et en référence à la formule I, Z est un groupement tertbutyle et A est un groupement triéthoxysilane.

Les molécules préférées de formule I et de formule I' sont les molécules de formules L, M et N suivantes :

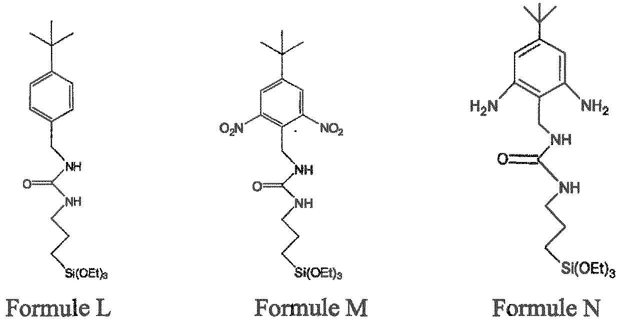

### Exemple :

Les molécules de formules L, M et N suivantes : 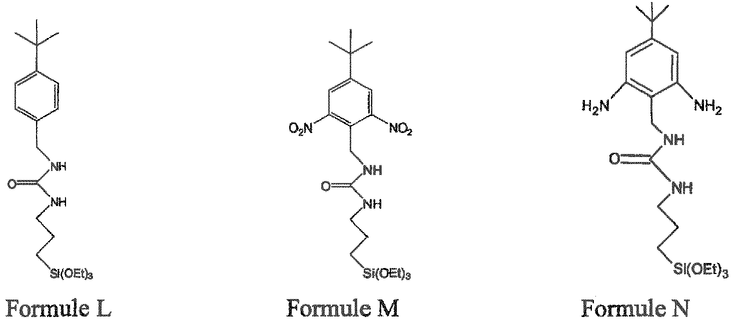 sont synthétisées et purifiées, puis greffées indépendamment sur des dispositifs électriques. Ces dispositifs électriques ont été fabriqués sur un substrat de silicium recouvert d'une couche d'oxyde de silicium d'une épaisseur de 100 nm. Des électrodes en Ti/Au (5/30 nm) ont été déposées par évaporation sur la surface d'oxyde de silicium (silice), qui constitue le matériau diélectrique isolant du dispositif électrique selon l'invention. La surface de la couche d'oxyde de silicium est activée par un traitement plasma oxygène (20 mTorr = 2.67 Pa, 10 sccm O₂, 10W, 300 s) pour créer des fonctions hydroxyles de surface. La surface est ensuite fonctionnalisée par immersion à température ambiante pendant 24 heures dans une solution 1mM de composé de formule L, de formule M ou de formule N, dans du toluène. Le substrat est ensuite rincé abondamment avec du dichlorométhane, de l'eau et de l'acétone puis séché sous flux d'argon. Les angles de gouttes à l'eau des surfaces obtenues à partir des molécules de formules L, M et N sont, respectivement, mesurées à 78°, 76° et 75°. Le moment dipolaire, calculé sur la partie « D+Z » de la molécule de formule L est de 0,2 Debye, celui calculé sur la partie « D+Z » de la molécule de formule M est de 0,2 Debye et celui calculé sur la partie « D+Z » de la molécule de formule N est de -1,7 Debye.

Un semiconducteur de type cristallin, le pentacène, est ensuite déposé par évaporation sur chaque dispositif pour former un transistor. Les performances électriques mesurées entre les trois transistors sont similaires, à l'exception de la tension de seuil qui est de -0,5 V pour le transistor réalisé avec la molécule de formule L, de +19,5 V pour le transistor réalisé avec la molécule de formule M et de -9,0 V pour le transistor réalisé avec la molécule de formule N. Hormis cette variation de tension de seuil, les performances sont similaires pour les transistors, et notamment la mobilité qui, pour les trois dispositifs, est mesurée entre 1x10⁻² et 3x10⁻² cm².V⁻¹.s⁻¹.

Sans la fonctionnalisation avec l'une des molécules de formule L, de formule M ou de formule N, le même transistor que synthétisé ci-dessus présente une tension de seuil de -7,0 V.

Ainsi, on voit qu'avec les molécules de formule I, on peut ajuster à volonté la tension de seuil d'un transistor sans changer ses autres propriétés et performances électriques.

On peut également greffer les molécules L, M ou N sur deux transistors placés sur un même support, en utilisant un masque et des dépôts successifs ou localisés par jet liquide, sérigraphie,...

Bien entendu, le nombre de transistors dans le dispositif électronique de l'invention peut être supérieur à 2, à condition que les moments dipolaires de chacune des molécules utilisées pour réaliser les couches auto-assemblées des différents transistors diffèrent de 0,2 à 10 Debye.

L'invention se place dans un contexte industriel et scientifique important car les circuits à base de transistors organiques ont de nombreuses applications en électronique organique, et peuvent être obtenus à bas coûts sur des grandes surfaces et sur des surfaces souples.

## Revendications

1. Dispositif électronique comprenant un premier transistor organique ayant une tension de seuil V₁ et au moins un second transistor organique ayant une tension de seuil V₂, V₁ et V₂ différant de l'un de l'autre d'une valeur d'au moins 0,2 V, chacun des premier et second transistors comprenant une couche en un matériau semiconducteur, au dessus d'une couche en un matériau diélectrique, et comprenant de plus :
- une première couche auto-assemblée de molécules ayant un premier moment dipolaire M₁, entre la couche en matériau diélectrique et la couche en un matériau semiconducteur du premier transistor organique, et
- une seconde couche auto-assemblée de molécules ayant un second moment dipolaire M₂, entre la couche en un matériau diélectrique et la couche en un matériau semiconducteur du second transistor organique,
les molécules à partir desquelles les couches auto-assemblées du premier et du au moins un second transistors organiques ayant la formule I suivante :
A-D-Z Formule I
dans laquelle :
- A est un groupement de greffage de la molécule de formule I sur le matériau diélectrique, de préférence un groupement trihalogénosilane, trialcoxysilane, acide carboxylique, acide phosphorique, un groupe insaturé, de préférence comprenant un groupement vinylique ou acétylènique, un sel de diazonium, un azoture, un composé initiateur de radicaux, un isocyanate, un groupement de type organolithien, organomagnésien, ou organozincique, ou acide sulfonique,
- Z est un groupement terminal comprenant de 3 à 8 atomes de carbone, linéaire ou ramifié ou aromatique, comprenant optionnellement au moins un atome de fluor,
- D est une chaine carbonée linéaire ou ramifiée, saturée ou insaturée, comprenant éventuellement un groupe cyclique, éventuellement aromatique et/ou plusieurs hétéroatomes,
et
la différence entre la valeur d'angle de goutte à l'eau de la couche auto-assemblée du premier transistor organique et la valeur de l'angle de goutte à l'eau de la couche auto-assemblée du au moins un second transistor organique étant inférieure à 5%, de préférence inférieure à 3%, et
la valeur absolue de la différence entre le moment dipolaire M₁ et le moment dipolaire M₂, |M₁-M₂| est comprise entre 0,2 et 10 Debye.

2. Procédé de fabrication d'un circuit électronique comprenant un premier transistor organique et au moins un second transistor organique, chacun des premier et au moins un second transistors organiques comprenant une couche en un matériau semiconducteur au dessus d'une couche en un matériau diélectrique et comprenant les étapes suivantes :
a) formation sur la couche en un matériau diélectrique du premier transistor, d'une couche auto-assemblée formée à partir de molécules ayant un moment dipolaire M₁, et
b) une étape de formation, sur la couche en un matériau diélectrique d'au moins un second transistor organique, d'une couche auto-assemblée formée à partir de molécules ayant un moment dipolaire M₂, tel que la valeur absolue, |M₁-M₂|, est comprise entre 0,2 et 10 Debye,
les molécules à partir desquelles les couches auto-assemblées du premier et du au moins un second transistors organiques ayant la formule I suivante :
A-D-Z Formule I
dans laquelle :
- A est un groupement de greffage de la molécule de formule I sur le matériau diélectrique, de préférence un groupement trihalogénosilane, trialcoxysilane, acide carboxylique, acide phosphorique, un groupe insaturé, de préférence comprenant un groupement vinylique ou acétylènique, un sel de diazonium, un azoture, un composé initiateur de radicaux, un isocyanate, un groupement de type organolithien, organomagnésien, ou organozincique, ou acide sulfonique,
- Z est un groupement terminal comprenant de 3 à 8 atomes de carbone, linéaire ou ramifié ou aromatique, comprenant optionnellement au moins un atome de fluor,
- D est une chaine carbonée linéaire ou ramifiée, saturée ou insaturée, comprenant éventuellement un groupe cyclique, éventuellement aromatique et/ou plusieurs hétéroatomes,
et
la différence entre la valeur d'angle de goutte à l'eau de la couche auto-assemblée du premier transistor organique et la valeur de l'angle de goutte à l'eau de la couche auto-assemblée du au moins un second transistor organique étant inférieure à 5%, de préférence inférieure à 3%.

3. Procédé selon la revendication 2 **caractérisé en ce que** le matériau diélectrique des premier et au moins un second transistors est de la silice, de l'alumine ou un polymère oxydé en surface, et **en ce que** le groupement de greffage A des molécules de formule I est un groupement trihalogénosilane ou trialcoxy (en C₁ à C₄) silane, de préférence un groupement triméthoxysilane, trichlorosilane ou triéthoxysilane.

4. Procédé selon la revendication 2 ou 3 **caractérisé en ce que** le groupement D comprend un noyau aromatique éventuellement substitué.

5. Procédé selon l'une quelconque des revendications 2 à 4 **caractérisé en ce que** le groupe terminal Z dans les composés de formule I est choisi parmi un groupe aromatique et/ou un groupe alkyle, linéaire ou ramifié en C₃ à C₈, saturé ou insaturé, comprenant optionnellement un atome de fluor, de préférence Z est choisi parmi un groupe terbutyle, isopropyle, adamantyle, perfluoroethyle, benzyle ou butyle.

6. Procédé selon l'une quelconque des revendications 2 à 5 **caractérisé en ce que** les molécules de formule I à partir desquelles les couches auto-assemblées des transistors sont formées, ont la formule I' suivante : 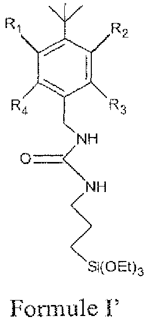 dans laquelle R₁, R₂, R₃ et R₄ sont indépendamment les uns des autres choisis parmi des groupements électro-attracteurs ou électro-donneurs.

7. Procédé selon la revendication 6 **caractérisé en ce que** les groupements R₁, R₂, R₃ et R₄ sont choisis chacun indépendamment les uns des autres parmi un atome d'hydrogène un groupe alkyle en C₁-C₁₀ substitué ou non substitué, un atome d'halogène, un groupe nitro (-NO₂), ester, amide, trichlorométhyle, dialkylamine, alcoxy, cyano, aldéhyde, cétone, acide carboxylique (-COOH) ou amine (-NH₂), de préférence choisi parmi un atome d'hydrogène, un groupe nitro et un groupe amine.

8. Procédé selon l'une quelconque des revendications 2 à 7 **caractérisé en ce que** les molécules de formule I à partir desquelles sont formées les couches auto-assemblées des transistors sont choisies parmi les molécules de formule L, de formule M et de formule N suivantes :

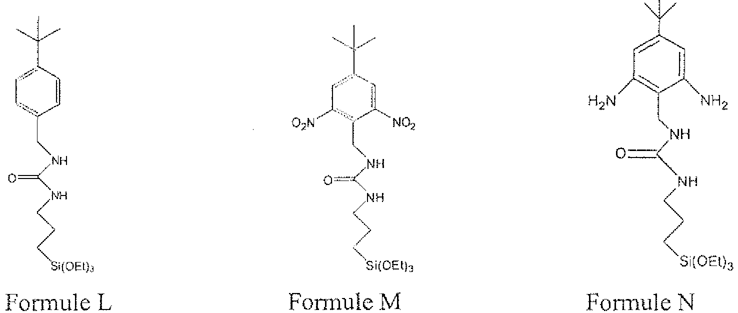

## Patentansprüche

1. Elektronische Vorrichtung, umfassend einen ersten organischen Transistor mit einer Schwellenspannung V₁ und mindestens einen zweiten organischen Transistor mit einer Schwellenspannung V₂, wobei sich V₁ und V₂ voneinander um einen Wert von mindestens 0,2 V unterscheiden, wobei sowohl der erste als auch der zweite Transistor eine Schicht aus einem Halbleitermaterial über einer Schicht aus einem dielektrischen Material umfassen, weiter umfassend:
- eine erste selbstassemblierte Schicht von Molekülen mit einem ersten Dipolmoment M₁ zwischen der Schicht aus dielektrischem Material und der Schicht aus einem Halbleitermaterial des ersten organischen Transistors, und
- eine zweite selbstassemblierte Schicht von Molekülen mit einem zweiten Dipolmoment M₂ zwischen der Schicht aus einem dielektrischen Material und der Schicht aus einem Halbleitermaterial des zweiten organischen Transistors,
wobei die Moleküle, aus denen die selbstassemblierten Schichten des ersten und des mindestens einen zweiten organischen Transistors die folgende Formel I aufweisen:
A-D-Z Formel I
in der:
- A eine Gruppe zum Pfropfen des Moleküls der Formel I auf das dielektrische Material ist, vorzugsweise eine Gruppe Trihalogensilan, Trialkoxysilan, Carbonsäure, Phosphorsäure, eine ungesättigte Gruppe, vorzugsweise mit einer Vinyl- oder Acetylengruppe, ein Diazoniumsalz, ein Azid, eine radikalinitiierende Verbindung, ein Isocyanat, eine Gruppe vom Typ Organolithium, Organomagnesium oder Organozink oder Sulfonsäure,
- Z eine Endgruppe mit 3 bis 8 Kohlenstoffatomen ist, linear oder verzweigt oder aromatisch, optional mit mindestens einem Fluoratom,
- D eine lineare oder verzweigte, gesättigte oder ungesättigte Kohlenstoffkette ist, die gegebenenfalls eine cyclische, gegebenenfalls aromatische Gruppe und/oder mehrere Heteroatome enthält,
und
wobei die Differenz zwischen dem Wert des Wasserkontaktwinkels der selbstassemblierten Schicht des ersten organischen Transistors und dem Wert des Wasserkontaktwinkels der selbstassemblierten Schicht des mindestens einen zweiten organischen Transistors weniger als 5%, vorzugsweise weniger als 3%, beträgt, und
der absolute Wert der Differenz zwischen dem Dipolmoment M₁ und dem Dipolmoment M₂, |M₁-M₂| zwischen 0,2 und 10 Debye liegt.

2. Verfahren zur Herstellung einer elektronischen Schaltung, umfassend einen ersten organischen Transistor und mindestens einen zweiten organischen Transistor, wobei sowohl der erste als auch der mindestens eine zweite organische Transistor eine Schicht aus einem Halbleitermaterial über einer Schicht aus einem dielektrischen Material umfasst, wobei das Verfahren die folgenden Schritte umfasst:
a) Bilden, auf der Schicht aus einem dielektrischen Material des ersten Transistors, einer aus Molekülen mit einem Dipolmoment M₁ gebildeten selbstassemblierten Schicht, und
b) einen Schritt zum Bilden, auf der Schicht aus einem dielektrischen Material mindestens eines zweiten organischen Transistors, einer selbstassemblierten Schicht, die aus Molekülen mit einem Dipolmoment M₂ gebildet wird, so dass der Absolutwert |M₁-M₂| zwischen 0,2 und 10 Debye liegt,
wobei die Moleküle, aus denen die selbstassemblierten Schichten des ersten und des mindestens einen zweiten organischen Transistors die folgende Formel I aufweisen:
A-D-Z Formel I
in der:
- A eine Gruppe zum Pfropfen des Moleküls der Formel I auf das dielektrische Material ist, vorzugsweise eine Gruppe Trihalogensilan, Trialkoxysilan, Carbonsäure, Phosphorsäure, eine ungesättigte Gruppe, vorzugsweise mit einer Vinyl- oder Acetylengruppe, ein Diazoniumsalz, ein Azid, eine radikalinitiierende Verbindung, ein Isocyanat, eine Gruppe vom Typ Organolithium, Organomagnesium oder Organozink oder Sulfonsäure,
- Z eine Endgruppe mit 3 bis 8 Kohlenstoffatomen ist, linear oder verzweigt oder aromatisch, optional mit mindestens einem Fluoratom,
- D eine lineare oder verzweigte, gesättigte oder ungesättigte Kohlenstoffkette ist, die gegebenenfalls eine cyclische, gegebenenfalls aromatische Gruppe und/oder mehrere Heteroatome enthält,
und
wobei die Differenz zwischen dem Wert des Wasserkontaktwinkels der selbstassemblierten Schicht des ersten organischen Transistors und dem Wert des Wasserkontaktwinkels der selbstassemblierten Schicht des mindestens einen zweiten organischen Transistors weniger als 5%, vorzugsweise weniger als 3%, beträgt.

3. Verfahren nach Anspruch 2, **dadurch gekennzeichnet, dass** das dielektrische Material des ersten und des mindestens einen zweiten Transistors Siliciumoxid, Aluminiumoxid oder ein oberflächenoxidiertes Polymer ist, und dass die Pfropfgruppe A der Moleküle der Formel I eine Gruppe Trihalogensilan oder Trialkoxy (in C1 bis C4) silan, vorzugsweise eine Gruppe Trimethoxysilan, Trichlorsilan oder Triethoxysilan ist.

4. Verfahren nach Anspruch 2 oder 3, **dadurch gekennzeichnet, dass** die Gruppe D einen aromatischen, gegebenenfalls substituierten Ring umfasst.

5. Verfahren nach einem der Ansprüche 2 bis 4, **dadurch gekennzeichnet, dass** die Endgruppe Z in den Verbindungen der Formel I ausgewählt ist aus einer aromatischen Gruppe und/oder einer linearen oder in C₃ bis C₈ verzweigten, gesättigten oder ungesättigten Alkylgruppe, die optional ein Fluoratom enthält, Z vorzugsweise ausgewählt ist aus einer Gruppe Terbutyl, Isopropyl, Adamantyl, Perfluorethyl, Benzyl oder Butyl.

6. Verfahren nach einem der Ansprüche 2 bis 5, **dadurch gekennzeichnet, dass** die Moleküle der Formel I, aus denen die selbstassemblierten Schichten der Transistoren gebildet werden, die folgende Formel I' aufweisen: 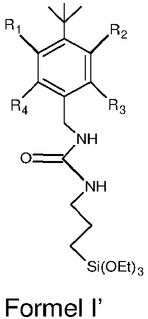 in der R₁, R₂, R₃ und R₄ unabhängig voneinander aus elektronenanziehenden oder elektronenabgebenden Gruppen ausgewählt sind.

7. Verfahren nach Anspruch 6, **dadurch gekennzeichnet, dass** die Gruppen R₁, R₂, R₃ und R₄ jeweils unabhängig voneinander ausgewählt sind aus einem Wasserstoffatom, einer substituierten oder unsubstituierten C₁-C₁₀-Alkylgruppe, einem Halogenatom, einer Gruppe Nitro (-NO₂), Ester, Amid, Trichlormethyl, Dialkylamin, Alkoxy, Cyano, Aldehyd, Keton, Carbonsäure (-COOH) oder Amin (-NH₂), vorzugsweise ausgewählt aus einem Wasserstoffatom, einer Nitrogruppe und einer Amingruppe.

8. Verfahren nach einem der Ansprüche 2 bis 7, **dadurch gekennzeichnet, dass** die Moleküle der Formel I, aus denen die selbstassemblierten Schichten der Transistoren gebildet werden, aus den folgenden Molekülen der Formel L, Formel M und Formel N ausgewählt werden:

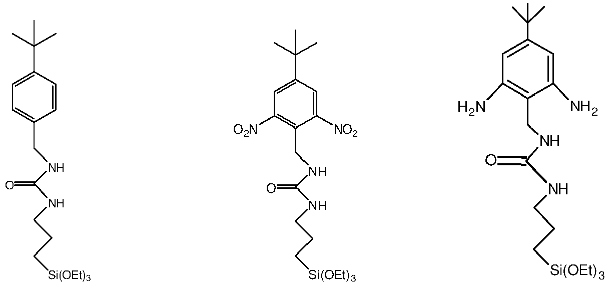

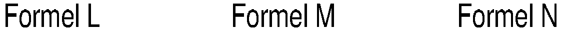

## Claims

1. Electronic device comprising a first organic transistor having a threshold voltage V₁ and at least one second organic transistor having a threshold voltage V₂, V₁ and V₂ differing from one another by a value of at least 0.2V, each of the first and second transistors comprising a layer made of a semi-conductive material, above a layer made of a dielectric material, and comprising in addition:
- a first self-assembled layer of molecules having a first dipole moment M₁, between the layer made of a dielectric material and the layer made of a semi-conductive material of the first organic transistor, and
- a second self-assembled layer of molecules having a second dipole moment M₂, between the layer made of a dielectric material and the layer made of a semi-conductive material of the second organic transistor,
the molecules from which the self-assembled layers of the first and of the at least one second organic transistor having the following formula I:
A-D-Z Formula I
wherein:
- A is a group for grafting the molecule of formula I on the dielectric material, preferably a trihalogenosilane, trialcoxysilane, carboxylic acid, phosphoric acid group, an unsaturated group, preferably comprising a vinyl or acetylenic group, a diazonium salt, an azide, a radical-initiating compound, an isocyanate, a organolithium, organomagnesium, or organozinc, or sulphonic acid group,
- Z is a terminal group comprising 3 to 8 carbon atoms, linear or ramified or aromatic, optionally comprising at least one fluorine atom,
- D is a linear or ramified carbon chain, saturated or unsaturated, possibly comprising a cyclic, possibly aromatic group and/or several heteroatoms,
and
the difference between the value of the angle of the waterdrop of the self-assembled layer of the first organic transistor and the value of the angle of the waterdrop of the self-assembled layer of the at least one second organic transistor being less than 5%, preferably less than 3%, and
the absolute value of the difference between the dipole moment M₁ and the dipole moment M₂, |M₁-M₂| is of between 0.2 and 10 Debye.

2. Method for manufacturing an electronic circuit comprising a first organic transistor and at least one second organic transistor, each of the first and at least one second organic transistor comprising a layer made of a semi-conductive material above a layer made of a dielectric material and comprising the following steps:
a) forming the layer made of a dielectric material of the first transistor, of a self-assembled layer, formed from molecules having a dipole moment M₁, and
b) a step of forming, on the layer made of a dielectric material of at least one second organic transistor, of a self-assembled layer formed from molecules having a dipole moment M₂, such as the absolute value, |M₁-M₂|, is of between 0.2 and 10 Debye,
the molecules from which the self-assembled layers of the first and of at least one second organic transistor having the following formula I:
A-D-Z Formula I
wherein:
- A is a group for grafting the molecule of formula I on the dielectric material, preferably a trihalogenosilane, trialcoxysilane, carboxylic acid, phosphoric acid group, an unsaturated group, preferably comprising a vinyl or acetylenic group, a diazonium salt, an azide, a radical-initiating compound, an isocyanate, a organolithium, organomagnesium, or organozinc, or sulphonic acid group,
- Z is a terminal group comprising 3 to 8 carbon atoms, linear or ramified or aromatic, optionally comprising at least one fluorine atom,
- D is a linear or ramified carbon chain, saturated or unsaturated, possibly comprising a cyclic, possibly aromatic group and/or several heteroatoms,
and
the difference between the value of the angle of the waterdrop of the self-assembled layer of the first organic transistor and the value of the angle of the waterdrop of the self-assembled layer of the at least one second organic transistor being less than 5%, preferably less than 3%.

3. Method according to claim 2, **characterised in that** the dielectric material of the first and at least one second transistor is silica, alumina or a surface-oxidised polymer, and **in that** the grafting group A of the molecules of formula I is a trihalogenosilane or silane trialcoxy group (in C₁ to C₄), preferably a trimethoxysilane, trichlorosilane or triethyoxysilane group.

4. Method according to the claim 2 or 3, **characterised in that** the group D comprises a possibly substituted aromatic core.

5. Method according to any one of claims 2 to 4, **characterised in that** the terminal group Z in the compounds of formula I is selected from among an aromatic group and/or an alkyl group, linear or ramified in C₃ to C₈, saturated or unsaturated, optionally comprising a fluorine atom, preferably Z is selected from among a terbutyl, isopropyl, adamantyl, perfluoroethyl, benzyl or butyl group.

6. Method according to any one of claims 2 to 5, **characterised in that** the molecules of formula I from which the self-assembled layers of the transistors are formed, have the following formula I': 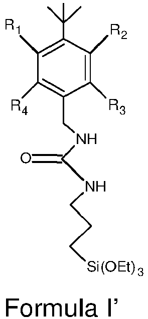 wherein R₁, R₂, R₃ and R₄ are independently from one another, selected from among electron-withdrawing or electron-donating groups.

7. Method according to claim 6, **characterised in that** the R₁, R₂, R₃ and R₄ groups are each selected independently from one another from among a hydrogen atom, an alkyl group in C₁-C₁₀ substituted or not substituted, a halogen atom, a nitro group (-NO₂), ester, amide, trichloromethyl, dialkylamine, alcoxy, cyano, aldehyde, ketone, carboxylic acid (-COOH) or amine (-NH₂), preferably selected from among a hydrogen atom, a nitro group and an amine group.

8. Method according to any one of claims 2 to 7, **characterised in that** the molecules of formula I from which are formed the self-assembled layers of the transistors are selected from among the molecules of following formula L, formula M and formula N:
